# EUROPEAN PATENT SPECIFICATION

(11) **EP 2 286 455 B1**
(45) Date of publication and mention of the grant of the patent: **10.04.2019**
(21) Application number: 09754266.6
(22) Date of filing: 20.05.2009
(51) Int. Cl.: H01L 29/78, H01L 29/739, H01L 29/08, H01L 21/336, H01L 21/331, H01L 21/324, H01L 21/74

(54) **TRENCH GATE SEMICONDUCTOR DEVICE AND METHOD OF MANUFACTURING THEREOF**
GRABEN-GATE-HALBLEITERBAUELEMENT UND VERFAHREN ZU SEINER HERSTELLUNG
DISPOSITIF À SEMI-CONDUCTEUR DOTÉ D'UNE STRUCTURE DE GRILLE EN TRANCHÉE ET SON PROCÉDÉ DE FABRICATION

(30) Priority: 28.05.2008 EP 08104137
(43) Date of publication of application: 23.02.2011
(73) Proprietor: Nexperia B.V., 6534 AB Nijmegen (NL)
(72) Inventor: SONSKY, Jan, Redhill, Surrey RH1 1DL (GB); SAARNILEHTO, Eero, Redhill, Surrey RH1 1DL (GB)
(74) Representative: Crawford, Andrew
(86) International application number: PCT/IB2009/052127
(87) International publication number: WO 2009/144640

(56) References cited:
- WO-A-03/096428
- US-B1- 6 262 453
- US-B1- 7 019 364
- PINARDI K ET AL: "High-power SOI vertical DMOS transistors with lateral drain contacts: Process developments, characterization, and modeling" IEEE TRANSACTIONS ON ELECTRON DEVICES, vol. 51, no. 5, May 2004 (2004-05), pages 790-796, XP011113455 IEEE, NEW YORK, NY, USA ISSN: 0018-9383
- SATO T ET AL: "Micro-structure transformation of silicon: a newly developed transformation technology for patterning silicon surfaces using the surface migration of silicon atoms by hydrogen annealing" JAPANESE JOURNAL OF APPLIED PHYSICS, PART 1, vol. 39, no. 9A, September 2000 (2000-09), pages 5033-5038, XP000977143 JAPAN SOCIETY OF APPLIED PHYSICS, TOKYO, JP ISSN: 0021-4922 cited in the application

## Description

The present invention relates to methods of manufacturing trench-gate semiconductor devices. More particularly, it concerns such devices which are suitable for incorporation in integrated circuits.

Trench-gate transistors are commonly used as discrete components in system-in-package (SiP) products able to handle high voltages and/or high currents. It is though beneficial to integrate the vertical devices into integrated circuits and thereby replace SiP products with a system-on-chip approach.

Known methods for integrating trench-gate devices into integrated circuits involve formation of a buried doped layer to provide the drain region, followed by epitaxial growth of a thick low doped silicon layer, and provision of connections to the buried layer by deep implants or trenches filled with conductive material. However, formation of the deep buried layer and subsequent growth of the epitaxial layer may have undesirable effects on other devices formed simultaneously on the same wafer.

WO2003/096428 describes a trench DMOS transistor structure. The transistor structure comprises a first region of semiconductor material of a first conductivity type, a gate trench formed within the first region, a layer of gate dielectric within the gate trench, a gate electrode within the gate trench adjacent the layer of gate dielectric material, a drain access trench formed within the first region, a drain access region of conductive material located within the drain access trench, a source region of the first conductivity type within the first region, the source region being at or near a top surface of the first region and adjacent to the gate trench, a body region within the first region below the source region and adjacent to the gate trench, a body region having a second conductivity type opposite to the first conductivity type, and a second region of semiconductor material within the first region below the body region.

An article entitled "High-power SOI vertical DMOS transistors with lateral drain contacts: Process developments, characterization, and modeling" by PINARDI K et al, published in IEEE Transactions on Electron Devices, vol. 51, no. 5, May 2004, pages 790-796, describes a back end of trench formation process for reducing defects in a device layer.

US 7019364 describes a semiconductor substrate having pillars within a closed empty space.

US6262453 discloses a DMOS power device supported on a substrate. The DOS power device includes a drain of a first conductivity type disposed at a bottom surface of the substrate. The DMOS power device further includes a gate disposed in a trench opened from a top surface of the substrate, the gate having a polysilicon layer filling the trenches padded by a double gate-oxide structure.

In accordance with the manufacturing methods described herein, devices embodying the invention can be fabricated without necessarily requiring thick epitaxial or buried doped layers, making them particularly suitable for integration into planar integrated circuit processes.

The drain region may be formed of doped semiconductor material, for example by epitaxial growth or deposition. The connection to it may be formed of metal to reduce the resistance thereof.

A semiconductor surface migration technique is thereby employed to define a self-aligned drain region below the trench in a manner compatible with integrated circuit processing.

The etching step can comprise etching a plurality of initial trenches into the semiconductor body, and the annealing step causes transformation of the initial trenches, such that the semiconductor body instead defines corresponding shallower trenches with a common cavity extending laterally below them. This facilitates formation of a drain region in the cavity which extends below the plurality of trenches in the finished device.

In accordance with an alternative embodiment, the etching step comprises etching a plurality of initial trenches into the semiconductor body;
the annealing step causes transformation of the initial trenches, such that the semiconductor body instead defines corresponding shallower trenches with an upper and a lower cavity extending laterally below them;
the drain forming step comprises forming the drain region in the upper cavity; and
the method includes a further step of filling the lower cavity with an insulating material, for example by oxidation of its sidewalls or deposition, to form the buried isolation layer.

In a further variation, the etching step comprises etching a plurality of initial trenches into the semiconductor body;
the annealing step causes transformation of the initial trenches, such that the semiconductor body instead defines shallower trenches with respective upper and lower cavities below each trench;
the drain forming step comprises forming drain regions in the upper cavities; and
the method includes a further step of oxidizing the walls of the lower cavities such that the oxidized regions so formed merge to form the buried isolation layer.

The shape of the initial trench can be selected such that a predetermined trench shape is formed following transformation thereof during the semiconductor migration process. For example, the width of another portion of the initial trench may be greater than the width of a lower portion thereof. In one embodiment, this is achieved by tapering the walls of the trench over an upper portion thereof, such that its width decreases with depth along the tapered portion, whilst retaining a substantially vertical profile for the walls of the remaining, lower portion of the trench. Alternatively, an upper portion of the trench may have substantially parallel and vertical walls defining a first trench width, whilst a lower portion of the trench has substantially vertical parallel walls defining a second, narrower width.

Embodiments of the invention will now be described by way of example and with reference to the accompanying schematic drawings, wherein:
Figure 1 is a cross-sectional side view of a trench-gate transistor manufactured through a method according to the invention;
Figure 2 is a cross-sectional side view of a trench gate transistor manufactured through a method according to the invention and including dielectric isolation;
Figures 3A to 3C show a plan view, and two orthogonal cross-sectional side views along lines A-A and B-B as marked in Figure 3A, of a trench-gate transistor manufactured through a method according to the invention;
Figures 4A-C to 12A-C are views corresponding to those shown in Figure 3 representing successive stages in the manufacture of a trench-gate transistor device in accordance with a method embodying the invention;
Figures 13A-C to 17A-C show views corresponding to those of Figure 3 showing successive stages in the manufacture of a trench-gate transistor according to another embodiment of the invention;
Figures 18 and 19 are cross-sectional side views of further trench-gate transistor configurations manufactured through a method according to the invention;
Figures 20 and 21A-E illustrate modification of the initial trench configuration;
Figures 22A-B and 23A-B show top and cross-sectional side views of a semiconductor substrate to illustrate formation of dummy trenches before and after semiconductor migration, respectively; and
Figures 24 to 26 are plan, cross-sectional side and plan views, respectively, of a semiconductor substrate illustrating formation of connections to buried drain regions manufactured through a method according to the invention.

It should be noted that the figures are diagrammatic and not drawn to scale. Relative dimensions and proportions of parts of these figures have been shown exaggerated or reduced in size, for the sake of clarity and convenience in the drawings. The same reference signs are generally used to refer to corresponding or similar features in modified and different embodiments.

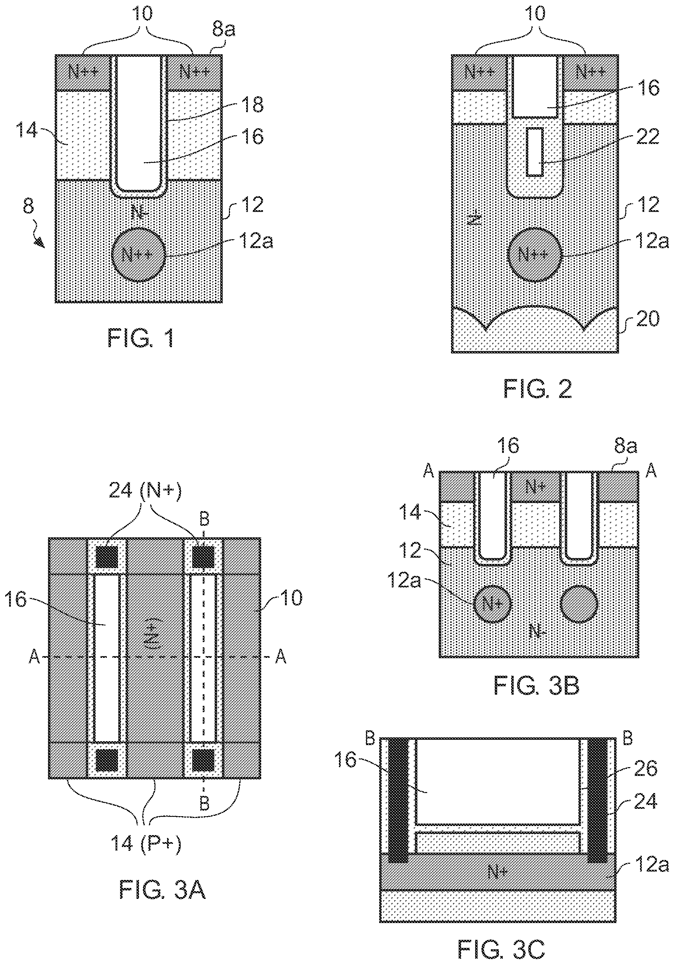

The manufacturing processes and device configurations described herein utilise an effect referred to as "silicon surface migration", as described for example in "Micro-structure transformation of silicon: A newly developed transformation technology for patterning silicon surfaces using the surface migration of silicon atoms by hydrogen annealing" by T. Sato et al, Jpn. J. Appl. Phys. 39, pp.5033-5038, 2000. Thermal treatment of a silicon substrate at low pressure in a hydrogen ambient atmosphere has been found to lead to reorganisation of the surface of the silicon through silicon atom migration, so that the total surface energy is reduced. For example, appropriately shaped trenches or trench arrays can be transformed into buried cavities having a tubular or planar configuration, as described in "Empty-space-in-silicon technique for fabricating a silicon-on-nothing structure" by I. Mizushima et al, Appl. Phys. Let. 77(20), pp. 3290-3292. Processes have also been disclosed in which a trench is transformed into a shallower trench with a tubular cavity beneath, for example as described in "Trench transformation technology using hydrogen annealing for realising highly reliable device structure with thin dielectric films", VLSI 1998 Conference Proceedings. According to methods described herein, such a structure is used to build a trench-gate field effect transistor having a configuration exemplified by Figure 1.

A hydrogen anneal leads to transformation of an initial trench to form a buried tubular cavity below an essentially unaltered trench. A drain region is formed in the buried tube or pipe by epitaxy and filling with conductive material. In the device of Figure 1, source and drain 10 and 12, 12a respectively, of a first conductivity type (n-type in this example) are separated by a channel-accommodating region 14 of the opposite, second conductivity type (i.e. p-type in this example in which case it may also be referred to as the p-body region). The drain comprises a low doped drift region 12 adjacent a drain region 12a.

A gate electrode 16 is present in a trench 18 which extends through the source and channel-accommodating regions 10, 14 into an underlying portion of the drift region 12. The source region 10 is contacted by a source electrode (not shown) at the top major surface 8a of the semiconductor body 8. Drain region 12a extends to the top major surface 8a outside the plane shown in Figure 1 for contact by a drain electrode (not shown) as discussed further below. The application of a voltage signal to the gate 16 in the on-state of the device serves in a known manner for inducing a conduction channel in the region 14 and for controlling current flow in this channel between the source and drain 10 and 12, 12a.

By modifying the processing used to form the device shown in Figure 1, two buried tubes made be formed under the trench, with the upper one defining the drain region and the lower one used to build an isolation layer 20 as shown in Figure 2.

Figure 2 also illustrates that the methods described herein are equally applicable to a range of trench-gate device configurations. As shown in the example of Figure 2, a trenched field plate 22 is provided below the gate electrode. Similarly, a trench field plate may be provided which is an extension of the gate electrode into a portion of the trench which extends into the drift region 12.

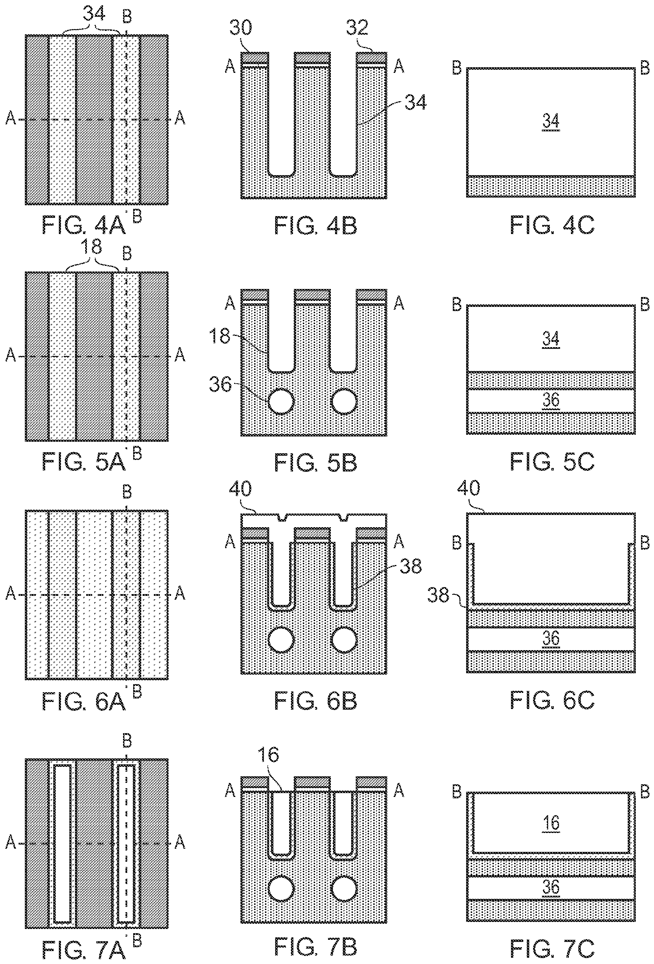

Figures 3A to 3C represent plan and cross-sectional views of an n-channel trench-gate transistor manufactured according to the embodiment of the invention. Corresponding views of successive stages in the manufacture of this device are show in Figures 4 to 14 and are discussed below.

As shown in Figure 3, conductive drain plugs 24 are provided in trenches 26 which extend from the top major surface 8a of the semiconductor body 8 down to the drain regions 12a to facilitate electrical connection to the drain regions at the top major surface. In this embodiment, the drain plug trenches 26 are provided in alignment with the gate trenches 18, at each end of gate electrode 16.

In the process stage of Figure 4, oxide and nitride layers 30,32 have been deposited on top of the semiconductor body and patterned photolithographically to define a trench array. An etch process has then been carried out to form trenches 34.

Next, as shown in Figure 5, a hydrogen anneal is carried out so as to cause silicon surface migration in the manner described above to form tubular cavities 36 below respective trenches 18, which trenches are reduced in depth relative to trenches 34. This is followed by oxidation by the trench sidewalls to form gate oxide layer 38 and a doped polysilicon layer 40 is then deposited conformally to arrive at the stage shown in Figure 6. The polysilicon material is etched back to define the gate electrodes 16 (see Figure 7).

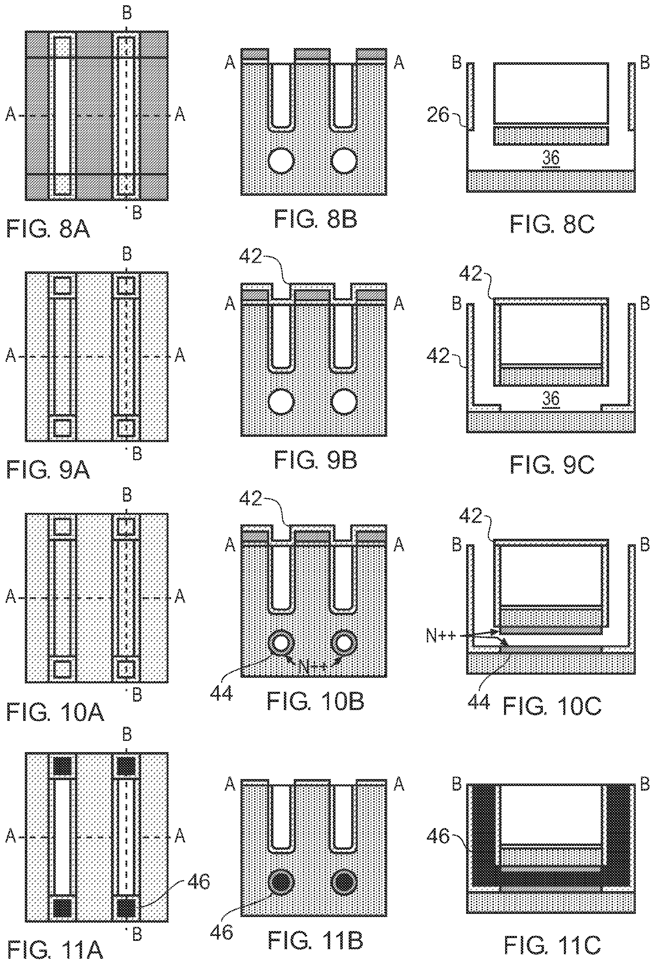

A mask is then defined over the semiconductor body which exposes polysilicon material at each end of the gate trenches. This material is then etched away to define drain plug trenches 26 which intersect with the horizontal drain tube 36, as shown in Figure 8.

A non-conformal oxide deposition process (for example plasma enhanced CVD or high density plasma deposition) is carried out which forms an oxide layer 42 over the vertical walls of drain plug trench 26 and the portion of the base of tube 36 exposed by trenches 26. It can be seen that the walls of tube 36 beneath the gate electrode are not covered by oxide layer 42 in Figure 9. Next, a layer of highly n-type doped epitaxial silicon 44 is selectively grown on the exposed walls of tube 36 to form a drain region extending around the walls of the tube (see Figure 10). Then as shown in Figure 11, electrically conductive material is deposited so as to fill tube 36 and trenches 26 and etched back to the top major surface 8a of the semiconductor body. Nitride layer is etched away. The conductive material, which may for example be doped polysilicon or a metal such as tungsten, forms a low-ohmic connection 46 to the buried drain region 44.

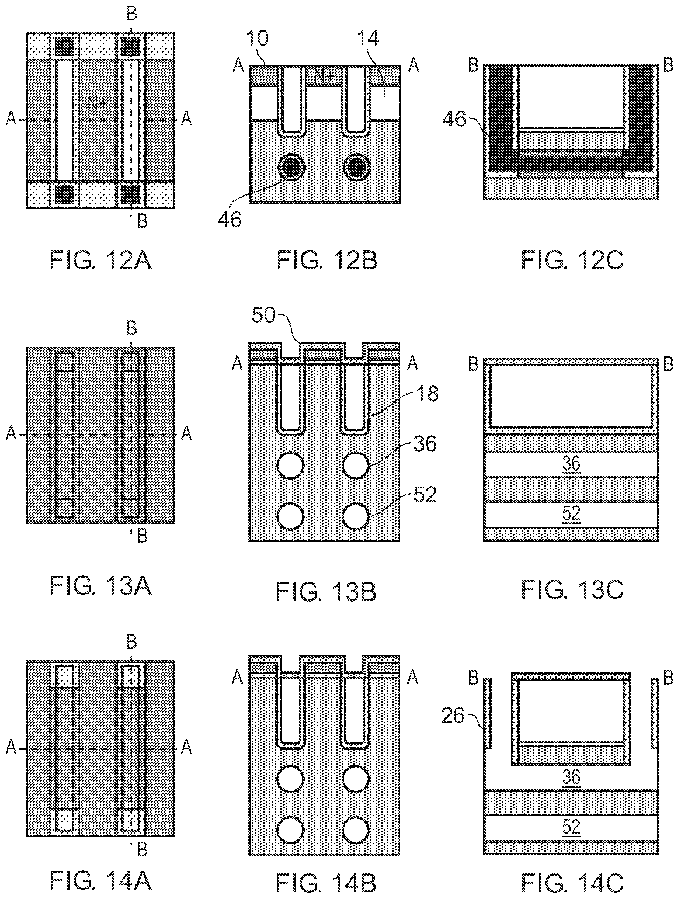

Next, the source and channel-accommodating regions 10, 14 are formed by successive implantations using an appropriately patterned photoresist mask (Figure 12). Electrical connections to the source, channel accommodating and drain regions, together with the gate electrode 16, are then formed over the top major surface 8a of the semiconductor body in a known manner.

A process of the form embodied in Figures 4 to 12 above may be modified to form an isolated trench-gate transistor configuration. The initial stages correspond to Figures 4 to 7 and then the modified process continues in accordance with the stages shown in Figures 13 to 17.

The trench definition and hydrogen anneal stages of Figures 4 and 5 are also modified such that dual buried tubes 36, 52 are formed successively below each trench 18.

As shown in Figure 13, a protective layer 50, of silicon nitride for example, is conformally deposited over the substrate. It serves to protect the gates 16 during later oxidation stages.

Drain plug trenches are then etched down to intersect with upper tube 36 at opposite ends of the gate electrodes 16 through windows defined photolithographically in a photoresist mask (Figure 14).

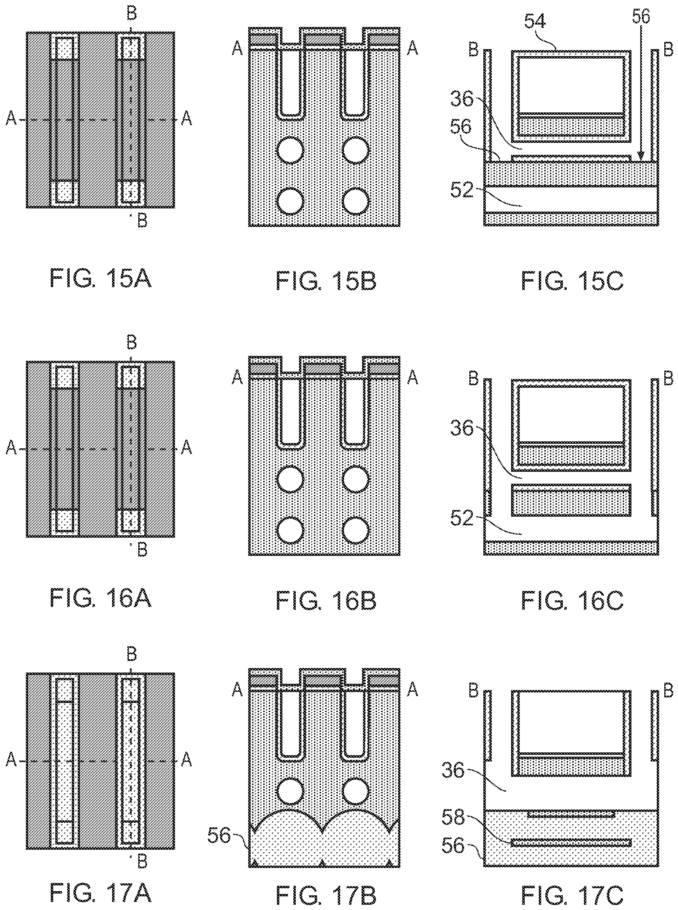

A layer 54 of an insulating material such as silicon nitride is uniformly deposited over the walls of trenches 26 and upper tube 36. An anisotropic etch process is carried out to open windows 56 at the base of each trench 26 (see Figure 15).

A further etch is then carried out through the material of the drain drift region via windows 56. The drain plug trenches 26 are thereby extended downwardly to intersect with lower tube 52, as depicted in Figure 16.

Next, the exposed walls of lower tube 52 are oxidised until the oxide regions so formed merge together to form a continuous buried oxide layer 56 (see Figure 17). It is possible that a small void 58 may remain within layer 56. Nitride layer 54 is then etched away to arrive at the configuration shown at Figure 17.

Further processing is then carried out in accordance with the method described above in relation to Figures 9 to 12.

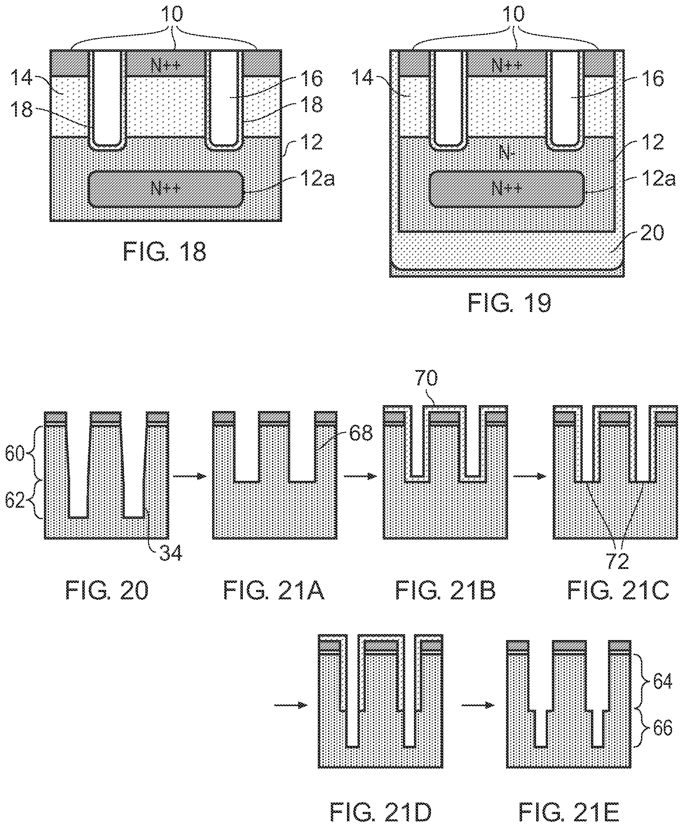

In accordance with a further embodiment of the invention, the network of initial trenches etched as shown in Figure 4 is configured such that buried planar cavities are obtained, instead of buried tubes, which extend laterally beneath a plurality of trenches. An example of a trench-gate transistor manufactured in this way is shown in Figure 18. A planar, elongate drain region 12a is shown extending beneath and between two gate trenches 18.

As the entire active device area may be suspended during part of processing in accordance with this embodiment, to facilitate manufacture it may be desirable to split up the device into smaller cells.

An isolated trench-gate transistor configuration embodying the invention is depicted in Figure 19. A buried isolation layer 20 is provided within a further plate-like or planar cavity created vertically below and spaced from drain region 12a. In this embodiment, the lower cavity may be filled using a conformal insulation layer deposition process instead of thermal oxidation. It can be seen that the resulting buried insulating layer 20 has a substantially uniform thickness underneath the entire device area.

The profile of the trenches initially etched into a substrate in accordance with embodiments of the invention may vary from a parallel sided configuration in order to adjust the cross-sectional profile of the trenches formed following silicon surface migration.

For example, as shown in Figure 20, an upper portion 60 of each trench may be formed with a tapered profile such that its width decreases with depth down to a lower portion 62 having vertical, parallel sides.

Successive stages in the formation of an alternative initial trench profile are shown in Figure 21. The resulting initial trenches shown in Figure 21E have an upper portion 64 with parallel vertical sides, and a lower portion 66 with parallel vertical sides, but with a reduced distance therebetween.

As a first step, trenches 68 are etched into the top major surface of the semiconductor body, with their depth generally corresponding to the trench depth desired following the transformation process. A conformal layer 70 of oxide for example is deposited and an anisotropic etch carried out to form windows 72 at the base of each trench. A further trench etch is then carried out via the windows 72 as shown in Figure 21D. Layer 70 is etched away to arrive at the configuration shown in Figure 21E. Provision of narrower lower trench portions 66 is conducive to formation of buried tubes whilst leaving the upper wider trench portions 64 unchanged.

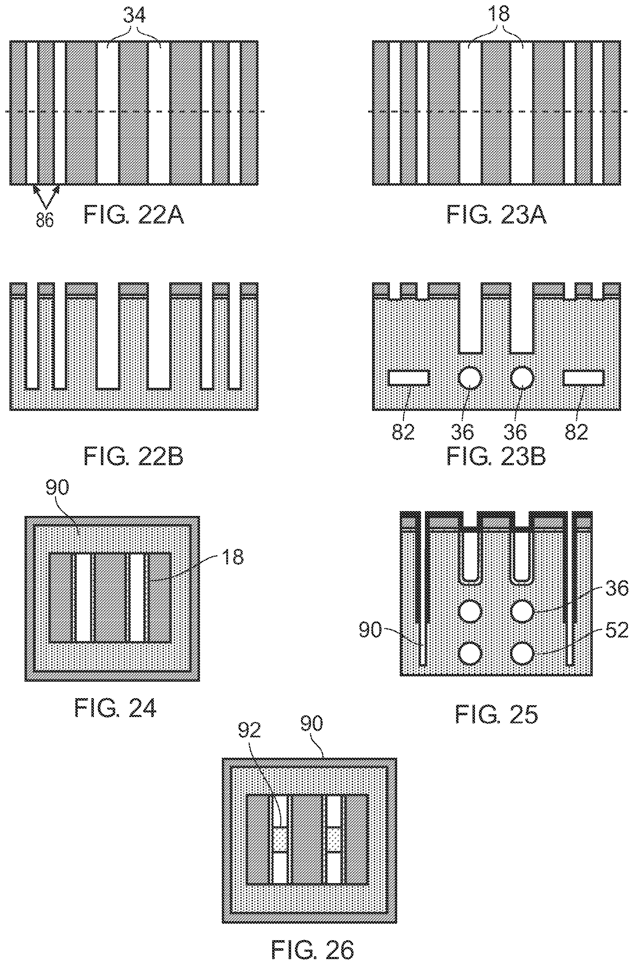

In some cases it may beneficial to provide one or more additional dummy trenches 80 spaced laterally from the device trenches, as depicted by way of example in Figure 22. These dummy trenches are preferably narrower and more closely spaced together than the device trenches, so that the dummy trenches are largely removed or refilled during the transformation process, as shown in Figure 33. Dummy tubular or planar cavities 82 are then formed alongside the cavities 36 beneath the device trenches 18.

These additional cavities 82 may be beneficial in formation of a fully isolated device (see below). These buried dummy-tubes or dummy-plates should be spaced apart from the buried cavities in the device area, so that they do not merge together.

Whilst drain plug trenches having a square cross-section in plan view are depicted in the process of Figures 4 to 12, in further embodiments, an elongate profile in plan view may be employed, which extends transversely across the device trench array. For example, in the isolated device configuration shown in Figure 24, the drain plug trench 90 may extend around the entire device active area. The portion of the trench extending parallel to the device trenches 18 is narrower than the portions running transversely with respect to the device trenches. This approach facilities full device isolation using a single plug trench mask. Subsequent processing steps are similar to those described above in relation to the isolated embodiment of Figure 13 to 17.

A cross-sectional view of the semiconductor body prior to oxidation to form the isolation region is shown in Figure 25. During oxidation, the silicon sidewall between the drain plug trench and the cavities 52 is fully oxidised. During the subsequent non-conformal oxide deposition step (corresponding to Figure 9 above), the narrower drain plug trenches parallel to the device trenches are completely filled, so that no conductive material is deposited there during the following process steps. This part of the drain plug trench acts as an isolation-surround trench. The dummy-approach described with reference to Figures 22 and 23 above may conveniently be used in combination with the surrounding drain plug trench to narrow the silicon sidewalls that need to be oxidised. It is necessary to ensure that these dummy-cavities do not merge with the cavities in the device area in this case to avoid separation of the device area from the remainder of the semiconductor body.

An alternative configuration for the drain plug trenches is shown in Figure 26. In this case, the drain connections are formed in the middle of the device trenches via drain plug trenches 92. It is preferable to have the (high voltage) drain connection towards the centre of the device.

In some cases, it may be preferable to enlarge the size of the drain cavity. This may be conveniently achieved by an isotropic etch or another hydrogen anneal prior to the stages shown in Figure 17 and/or 10 above.

It will be appreciated that whilst the drain region is shown in the embodiments discussed above as having the same conductivity type (n-type in these examples) as the drain drift region, the drain region may instead be of the opposite conductivity type (p-type in these examples) to provide a vertical IGBT.

The device trenches of the configurations shown in the drawings have an elongate stripe geometry. The techniques described herein are also applicable to other, cell geometries, such as a square or close-packed hexagonal geometry.

Instead of forming the conductive gate of the device from doped polycrystalline silicon, other known gate technologies may be used in particular devices, This, for example, additional material may be used for the gate, such as a thin metal layer that forms a silicide with the polycrystalline silicon material. Alternatively, the whole gate may be formed of metal instead of polycrystalline silicon. In place of an insulating gate structure, so-called Schottky gate technologies may be used. In this case, a gate dielectric layer is absent and the conductive gate is of a metal that forms a Schottky barrier with the channel-accommodating region.

The particular examples described above are n-channel devices. It would be appreciated that, by using opposite conductivity type dopants, a p-channel device can be manufactured in accordance with the invention.

## Claims

1. A method of manufacturing a trench gate semiconductor device, the semiconductor device comprising:
a semiconductor body (8) comprising a source region (10) and a drain drift region (12) of a first conductivity type, having therebetween a channel-accommodating region (14) of an opposite, second conductivity type;
an insulated gate (16) provided in a trench (18), the trench extending through the channel-accommodating region into the drain drift region;
a drain region (12a) located inside a buried tubular volume defined by the drain drift region, and surrounded by the drain drift region, wherein the drain region is more highly doped than the drain drift region and is provided below and in alignment with the trench,
the method including the steps of:
etching an initial trench (34) into a semiconductor body (8);
hydrogen annealing so as to cause migration of material in the semiconductor body and transformation of the initial trench, such that the semiconductor body defines a shallower trench (18) with a cavity (36) below it; and
forming the drain region (12a) in the cavity.

2. The method of claim 1, wherein the etching step comprises etching a plurality of initial trenches (34) into the semiconductor body (8), and the hydrogen annealing step causes transformation of the initial trenches, such that the semiconductor body defines corresponding shallower trenches (18) with a cavity (36) extending laterally below them.

3. The method of claim 1, wherein:
the etching step comprises etching a plurality of initial trenches (34) into the semiconductor body;
the hydrogen annealing step causes transformation of the initial trenches, such that the semiconductor body defines corresponding shallower trenches (18) with an upper and a lower cavity (36,52) extending laterally below them;
the drain forming step comprises forming the drain region (12a) in the upper cavity (36); and
the method includes a further step of filling the lower cavity (52) with an insulating material to form the buried isolation layer (20).

4. The method of claim 1, wherein:
the etching step comprises etching a plurality of initial trenches (34) into the semiconductor body (8);
the hydrogen annealing step causes transformation of the initial trenches, such that the semiconductor body defines shallower trenches (18) with respective upper and lower cavities (36,52) below each trench;
the drain forming step comprises forming drain regions (12a) in the upper cavities (36); and
the method includes a further step of oxidizing the walls of the lower cavities (52) such that the oxidized regions so formed merge to form the buried isolation layer (20).

5. The method of any of claims 1 to 4, wherein the width of an upper portion (60) of the or each initial trench (34) is greater than the width of a lower portion (62) thereof.

6. The method of claim 5, wherein the or each initial trench (34) is tapered over at least an upper portion (60) thereof, such that its width decreases with depth along the tapered portion.

7. A method of manufacturing an integrated circuit device, the method comprising the method of any of claims 1 to 6, for manufacturing a semiconductor device of the integrated circuit device.

## Patentansprüche

1. Verfahren zum Herstellen einer Trench-Gate-Halbleitervorrichtung, wobei die Halbleitervorrichtung Folgendes umfasst:
einen Halbleiterkörper (8), umfassend eine Source-Region (10) und eine Drain-Drift-Region (12) eines ersten Leitfähigkeitstyps, die dazwischen eine Kanalaufnahmeregion (14) eines entgegengesetzten, zweiten Leitfähigkeitstyps aufweisen;
ein in einem Graben (18) bereitgestelltes isoliertes Gate (16), wobei sich der Graben durch die Kanalaufnahmeregion in die Drain-Drift-Region erstreckt;
eine Drain-Region (12a), die sich in einem von der Drain-Drift-Region definierten, verdeckten röhrenförmigen Volumen befindet und von der Drain-Drift-Region umgeben ist, wobei die Drain-Region stärker dotiert ist als die Drain-Drift-Region und unter dem Graben und auf diesen ausgerichtet bereitgestellt ist,
wobei das Verfahren folgende Schritte umfasst:
Ätzen eines Ausgangsgrabens (34) in einen Halbleiterkörper (8);
Wasserstofftempern, um die Migration von Material in dem Halbleiterkörper und die Umwandlung des Ausgangsgrabens zu bewirken, sodass der Halbleiterkörper einen flacheren Graben (18) mit einem Hohlraum (36) darunter definiert; und
Bilden der Drain-Region (12a) in dem Hohlraum.

2. Verfahren nach Anspruch 1, wobei der Ätzschritt das Ätzen einer Vielzahl von Ausgangsgräben (34) in den Halbleiterkörper (8) umfasst und der Wasserstofftemperungsschritt die Umwandlung der Ausgangsgräben bewirkt, sodass der Halbleiterkörper entsprechende flachere Gräben (18) mit einem sich in Querrichtung darunter erstreckenden Hohlraum (36) definiert.

3. Verfahren nach Anspruch 1, wobei:
der Ätzschritt das Ätzen einer Vielzahl von Ausgangsgräben (34) in den Halbleiterkörper umfasst;
der Wasserstofftemperungsschritt die Umwandlung der Ausgangsgräben bewirkt, sodass der Halbleiterkörper entsprechende flachere Gräben (18) mit einem oberen und einem unteren Hohlraum (36, 52), die sich in Querrichtung darunter erstrecken, definiert;
der Drain-Bildungsschritt das Bilden der Drain-Region (12a) in dem oberen Hohlraum (36) umfasst; und
das Verfahren einen weiteren Schritt des Füllens des unteren Hohlraums (52) mit einem Isolierstoff umfasst, um die verdeckte Isolierschicht (20) zu bilden.

4. Verfahren nach Anspruch 1, wobei:
der Ätzschritt das Ätzen einer Vielzahl von Ausgangsgräben (34) in den Halbleiterkörper (8) umfasst;
der Wasserstofftemperungsschritt die Umwandlung der Ausgangsgräben bewirkt, sodass der Halbleiterkörper flachere Gräben (18) mit einem jeweiligen oberen und einem jeweiligen unteren Hohlraum (36, 52) unter jedem Graben definiert;
der Drain-Bildungsschritt das Bilden von Drain-Regionen (12a) in den oberen Hohlräumen (36) umfasst; und
das Verfahren einen weiteren Schritt des Oxidierens der Wände der unteren Hohlräume (52) umfasst, sodass die derart gebildeten oxidierten Regionen zusammenwachsen, um die verdeckte Isolierschicht (20) zu bilden.

5. Verfahren nach einem der Ansprüche 1 bis 4, wobei die Breite eines oberen Abschnitts (60) des oder jedes Ausgangsgrabens (34) größer ist als die Breite eines unteren Abschnitts (62) desselben.

6. Verfahren nach Anspruch 5, wobei der oder jeder Ausgangsgraben (34) über mindestens einem oberen Abschnitt (60) desselben verjüngt ist, sodass seine Breite entlang des verjüngten Abschnitts mit der Tiefe abnimmt.

7. Verfahren zum Herstellen einer integrierten Schaltungsvorrichtung, wobei das Verfahren das Verfahren nach einem der Ansprüche 1 bis 6 zum Herstellen einer Halbleitervorrichtung der integrierten Schaltungsvorrichtung umfasst.

## Revendications

1. Procédé de fabrication d'un dispositif semi-conducteur à grille en tranchée, le dispositif semi-conducteur comprenant :
un corps semi-conducteur (8) comprenant une région de source (10) et une région de dérive de drain (12) d'un premier type de conductivité, présentant entre elles une région d'hébergement de canal (14) d'un second type de conductivité opposé ;
une grille isolée (16) fournie dans une tranchée (18), la tranchée s'étendant à travers la région d'hébergement de canal jusque dans la région de dérive de drain ;
une région de drain (12a) située à l'intérieur d'un volume tubulaire noyé défini par la région de dérive de drain, et entourée par la région de dérive de drain, la région de drain étant plus fortement dopée que la région de dérive de drain et étant fournie en dessous de la tranchée et en alignement avec celle-ci,
le procédé comprenant les étapes de :
gravure d'une tranchée initiale (34) dans un corps semi-conducteur (8) ;
recuit à l'hydrogène de manière à entraîner une migration de matière dans le corps semi-conducteur et une transformation de la tranchée initiale, de telle sorte que le corps semi-conducteur définisse une tranchée moins profonde (18) avec une cavité (36) en-dessous d'elle ; et
la formation de la région de drain (12a) dans la cavité.

2. Procédé selon la revendication 1, dans lequel l'étape de gravure comprend la gravure d'une pluralité de tranchées initiales (34) dans le corps semi-conducteur (8), et l'étape de recuit à l'hydrogène entraîne la transformation des tranchées initiales, de telle sorte que le corps semi-conducteur définisse des tranchées moins profondes correspondantes (18) avec une cavité (36) s'étendant latéralement en-dessous d'elles.

3. Procédé selon la revendication 1, dans lequel:
l'étape de gravure comprend la gravure d'une pluralité de tranchées initiales (34) dans le corps semi-conducteur ;
l'étape de recuit à l'hydrogène entraîne la transformation des tranchées initiales, de telle sorte que le corps semi-conducteur définisse des tranchées moins profondes correspondantes (18) avec une cavité supérieure et une cavité inférieure (36, 52) s'étendant latéralement en-dessous d'elles ;
l'étape de formation de drain comprend la formation de la région de drain (12a) dans la cavité supérieure (36) ; et
le procédé comporte une étape supplémentaire de remplissage de la cavité inférieure (52) avec un matériau isolant pour former la couche d'isolation noyée (20).

4. Procédé selon la revendication 1, dans lequel :
l'étape de gravure comprend la gravure d'une pluralité de tranchées initiales (34) dans le corps semi-conducteur (8) ;
l'étape de recuit à l'hydrogène entraîne la transformation des tranchées initiales, de telle sorte que le corps semi-conducteur définisse des tranchées moins profondes (18) avec des cavités supérieure et inférieure respectives (36, 52) en-dessous de chaque tranchée ;
l'étape de formation de drain comprend la formation de régions de drain (12a) dans les cavités supérieures (36) ; et
le procédé comporte une étape supplémentaire d'oxydation des parois des cavités inférieures (52) de telle sorte que les régions oxydées ainsi formées fusionnent afin de former la couche d'isolation noyée (20).

5. Procédé selon l'une quelconque des revendications 1 à 4, dans lequel la largeur d'une partie supérieure (60) de la ou de chaque tranchée initiale (34) est supérieure à la largeur d'une partie inférieure (62) de celle-ci.

6. Procédé selon la revendication 5, dans lequel la ou chaque tranchée initiale (34) est effilée sur au moins une partie supérieure (60) de celle-ci, de telle sorte que sa largeur diminue avec la profondeur le long de la partie effilée.

7. Procédé de fabrication d'un dispositif à circuit intégré, le procédé comprenant le procédé selon l'une quelconque des revendications 1 à 6, pour fabriquer un dispositif semi-conducteur du dispositif à circuit intégré.
